# EUROPEAN PATENT APPLICATION

(11) **EP 3 675 094 A1**
(43) Date of publication of application: **01.07.2020**
(21) Application number: 18860893.9
(22) Date of filing: 28.09.2018
(51) Int. Cl.: G09G 3/00, G09G 3/32

(54) **DISPLAY DEVICE AND CONTROL METHOD FOR SAME**

(30) Priority: 29.09.2017 KR 20170127640
(71) Applicant: Samsung Electronics Co., Ltd., Suwon-si, Gyeonggi-do 16677 (KR)
(72) Inventor: IM, Sang Kyun, Seoul 01775 (KR); CHOI, Hye-Rin, Yongin-si Gyeonggi-do 16944 (KR)
(74) Representative: Appleyard Lees IP LLP
(86) International application number: PCT/KR2018/011599
(87) International publication number: WO 2019/066594

(57) **Abstract**

A display apparatus may include a plurality of LED modules; a plurality of module controllers configured to control the plurality of LED modules; a plurality of transmitters disposed on a rear surface of the plurality of LED modules, and configured to transmit a signal toward one of the adjacent LED modules among the plurality of LED modules; a plurality of receivers disposed on the rear surface of the plurality of LED modules, and configured to receive the signal transmitted from a transmitter of the adjacent LED module among the plurality of LED modules; and at least one operator configured to obtain an interval between the LED modules adjacent to each other using output values of the plurality of receivers.

## Description

### [Technical Field]

The present disclosure relates to a light emitting diode (LED) display apparatus and a method of controlling the same.

### [Background Art]

LED display apparatuses using light emitting diodes (LEDs) as light emitting devices have excellent brightness and color characteristics compared to other display apparatuses such as a display apparatus using a plasma display panel (PDP), a display apparatus using a cathode ray tube (CRT), a display apparatus using a liquid crystal display (LCD) panel and a backlight unit.

In addition, since the LED display apparatus has a modular structure in which a plurality of modules are arranged to form one large screen, the LED display apparatus may adjust a size of an entire screen or implement a desired shape in various ways.

Accordingly, the LED display apparatus may be used for various purposes such as indoor / outdoor billboards, indoor / outdoor information boards, stadium billboards, and indoor / outdoor backdrops.

### [Disclosure]

### [Technical Problem]

The present disclosure provides a display apparatus capable of measuring an alignment of an LED module simply and accurately by employing a simple sensor structure, and a method of controlling the same.

### [Technical Solution]

An aspect of the disclosure provides a display apparatus including: a plurality of LED modules; a plurality of module controllers configured to control the plurality of LED modules; a plurality of transmitters disposed on a rear surface of the plurality of LED modules, and configured to transmit a signal toward one of the adjacent LED modules among the plurality of LED modules; a plurality of receivers disposed on the rear surface of the plurality of LED modules, and configured to receive a signal transmitted from a transmitter of the adjacent LED module among the plurality of LED modules; and at least one operator configured to obtain an interval between the LED modules adjacent to each other using output values of the plurality of receivers.

The at least one operator may be configured to determine whether the interval between the LED modules adjacent to each other is included in a preset normal range.

The plurality of module controllers may be configured to increase brightness of LED elements disposed at boundaries of the LED modules adjacent to each other when the interval between the LED modules adjacent to each other is greater than a preset first reference value.

The plurality of module controllers may be configured to reduce brightness of LED elements disposed at boundaries of the LED modules adjacent to each other when the interval between the LED modules adjacent to each other is greater than a preset second reference value.

The at least one operator may be configured to determine an alignment state of the plurality of LED modules using output values of the plurality of receivers.

The at least one operator may be configured to compare the output values of the plurality of receivers with a preset reference value, and to determine that the alignment of the LED module in which the receiver that outputs the output value less than the preset reference value is misaligned when there is the output value less than the preset reference value among the output values of the plurality of receivers.

The plurality of LED modules may be arranged in a form of a one-dimensional or two-dimensional matrix on an XY plane.

At least one of the plurality of transmitters may be disposed on at least one edge of the plurality of LED modules. The plurality of receivers may be disposed at positions corresponding to the plurality of transmitters disposed in the adjacent LED modules.

At least one of the plurality of transmitters may be disposed at each of left and right edges of the plurality of LED modules. At least one of the plurality of receivers may be disposed at each of left and right edges of the plurality of LED modules.

At least one of the plurality of transmitters may be disposed at each of upper and lower edges of the plurality of LED modules. At least one of the plurality of receivers may be disposed at each of upper and lower edges of the plurality of LED modules.

The plurality of transmitters may include at least one of the transmitters disposed at a left edge of the LED module to transmit a signal toward the LED module adjacent to the left side; and at least one of the transmitters disposed at a right edge of the LED module to transmit a signal toward the LED module adjacent to the right side.

The plurality of receivers may include at least one of the receivers disposed at the left edge of the LED module to receive the signal transmitted from the transmitter of the LED module adjacent to the left side; and at least one of the receivers disposed at the right edge of the LED module to receive the signal transmitted from the transmitter of the LED module adjacent to the right side.

The plurality of transmitters may further include at least one of the transmitters disposed at an upper edge of the LED module to transmit the signal toward the LED module adjacent to the upper side; and at least one of the transmitters disposed at a lower edge of the LED module to transmit the signal toward the LED module adjacent to the lower side.

The plurality of receivers may further include at least one of the receivers disposed at the upper edge of the LED module to receive the signal transmitted from the transmitter of the LED module adjacent to the upper side; and at least one of the receivers disposed at the lower edge of the LED module to receive the signal transmitted from the transmitter of the LED module adjacent to the lower side.

The display apparatus may further include a communication circuitry configured to communicate with an external device. When the interval between the LED modules adjacent to each other is not within a preset normal range, the communication circuitry may be configured to transmit a warning about occurrence of a white seam or a black seam to the external device.

The signal transmitted by the plurality of transmitters and received by the plurality of receivers may include at least one of an electromagnetic waves signal, an ultrasonic signal, and a laser signal including infrared rays and visible light.

The at least one operator may include a plurality of the operators respectively corresponding to the plurality of LED modules. The plurality of operators may be configured to independently obtain an interval between the corresponding LED module and the adjacent LED module, respectively.

Another aspect of the disclosure provides a method of controlling a display apparatus including: transmitting signals toward LED modules adjacent to each other from a plurality of transmitters disposed at a rear surface of a plurality of the LED modules; receiving, by a plurality of receivers disposed at the rear surface of the plurality of LED modules, the signals transmitted from the plurality of transmitters disposed at the LED modules adjacent to each other; outputting, by the plurality of receivers, output values corresponding to strength of the received signals; and obtaining a distance between the LED modules adjacent to each other using the output values.

The method may further include determining whether an interval between the LED modules adjacent to each other is included in a preset normal range.

The method may further include increasing brightness of LED elements disposed at boundaries of the LED modules adjacent to each other when the interval between the LED modules adjacent to each other is greater than a preset first reference value.

The method may further include reducing brightness of LED elements disposed at boundaries of the LED modules adjacent to each other when the interval between the LED modules adjacent to each other is greater than a preset second reference value.

The method may further include determining an alignment state of the plurality of LED modules using the output values of the plurality of receivers.

The determining of the alignment state of the plurality of LED modules may include comparing the output values of the plurality of receivers with a preset reference value; and determining that the alignment of the LED module in which the receiver that outputs the output value less than the preset reference value is misaligned when there is the output value less than the preset reference value among the output values of the plurality of receivers.

The method may further include transmitting a warning about occurrence of a white seam or a black seam when the interval between the LED modules adjacent to each other is not within a preset normal range.

The method may further include transmitting a warning about occurrence of a white seam or a black seam to an external device when the interval between the LED modules adjacent to each other is not within a preset normal range.

### [Advantageous Effects]

According to a display apparatus and a method of controlling the same of an embodiment, it is possible to measure an alignment state of an LED module simply and accurately by employing a simple sensor structure. In addition, it is possible to measure the alignment state of the LED module in real time. When it is determined that there is a problem in the alignment state, by controlling brightness of an LED element independently for each of the LED modules, it is possible to promptly improve the degradation of image quality.

### [Description of Drawings]

FIGS. 1 and 2 are views illustrating an appearance of a display apparatus according to an embodiment.
FIG. 3 is a view illustrating a case where an interval between LED modules is normal and abnormal in a display apparatus according to an embodiment.
FIG. 4 is a view illustrating a case in which an alignment of an LED module is misaligned.
FIG. 5 is a control block diagram of a display apparatus according to an embodiment.
FIG. 6 is a view illustrating an example of arranging a sensing device applied to a display apparatus according to an embodiment.
FIG. 7 is a control block diagram illustrating a case where an operator is included in a module controller in a display apparatus according to an embodiment.
FIG. 8 is a control block diagram illustrating a case where a signal output from a plurality of LED modules is processed by one operator in a display apparatus according to an embodiment.
FIG. 9 is a view illustrating an interval measurement in a Y-axis direction of a plurality of LED modules having an arrangement of the sensing device of FIG. 6.
FIGS. 10 and 11 are views illustrating an arrangement of a sensing device that is possible when one operator receives an output of the sensing device from a plurality of LED modules.
FIGS. 12 and 13 are views for describing an operation of obtaining a distance between LED modules adjacent in an X-axis direction and a Y-axis direction when a plurality of the LED modules are arranged in a two-dimensional matrix form in a display apparatus according to an embodiment.
FIG. 14 is a view illustrating another arrangement of a sensing device that is possible when one operator receives an output of the sensing device from a plurality of LED modules.
FIGS. 15 and 16 are views illustrating an operation of a sensing device in a case in which an alignment of an LED module is misaligned in a display apparatus according to an embodiment.
FIGS. 17 to 20 are views illustrating a case in which a sensing device is provided in an array form in a display apparatus according to an embodiment.
FIG. 21 is a view illustrating a case in which an alignment of an LED module is misaligned in an X-axis direction in a display apparatus having an arrangement of the sensing device of FIG. 19.
FIG. 22 is a view illustrating a case in which an alignment of an LED module is misaligned in a Y-axis direction in a display apparatus having an arrangement of the sensing device of FIG. 19.
FIGS. 23 and 24 are views illustrating an operation for compensating for a case in which an interval between LED modules is abnormal.
FIG. 25 is a flowchart illustrating a control method for measuring an interval between LED modules and performing compensation according to the measured interval.
FIG. 26 is another flowchart related to a control method of determining a misalignment of an LED module in a method of controlling a display apparatus according to an embodiment.

### [Modes of the Invention]

Embodiments and features as described and illustrated in the present disclosure are only preferred examples, and various modifications thereof may also fall within the scope of the disclosure.

The terminology used herein is for the purpose of describing particular embodiments only and is not intended to limit the present disclosure.

For example, the singular forms as used herein are intended to include the plural forms as well, unless the context clearly indicates otherwise.

It will be further understood that the terms "comprises" and/or "comprising," when used in this specification, indicate the presence of stated features, integers, steps, operations, elements, and/or components, but do not preclude the presence or addition of one or more other features, integers, steps, operations, elements, components, and/or groups thereof.

Also, terms including ordinal numbers such as "first" and "second" are used to distinguish one component from another, and do not limit the order between the components.

Furthermore, the terms, such as "∼ part," "∼ block," "∼ member," "∼ module," etc., may refer to a unit of handling at least one function or operation. For example, the terms may refer to at least one process handled by hardware such as a field-programmable gate array (FPGA)/application specific integrated circuit (ASIC), etc., software stored in a memory, or a processor.

Hereinafter, with reference to the accompanying drawings will be described in detail an embodiment of the present disclosure. Like reference numerals or signs in the accompanying drawings may refer to parts or components that perform substantially the same function.

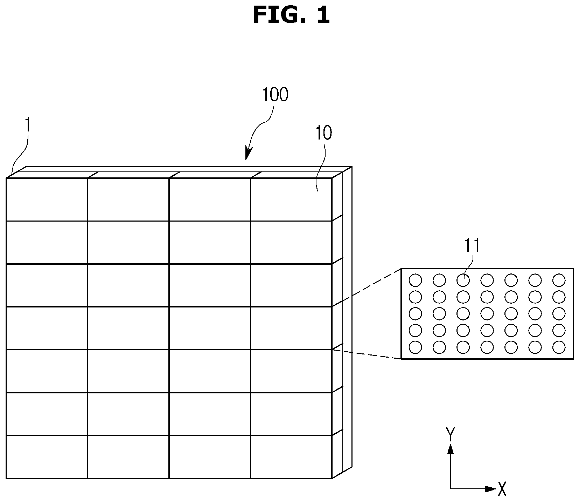

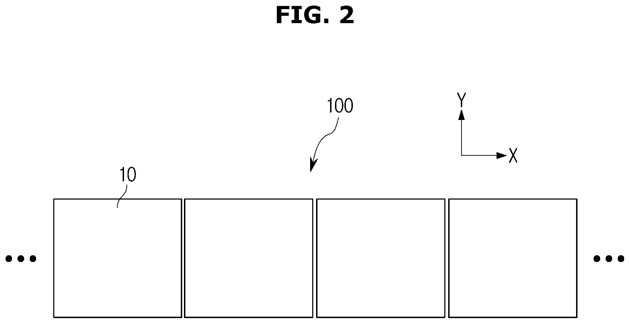

FIGS. 1 and 2 are views illustrating an appearance of a display apparatus according to an embodiment.

Referring to FIGS. 1 and 2, a display apparatus 100 according to an embodiment may be configured with a plurality of LED modules 10, and each of the LED modules 10 may include a plurality of LED elements 11.

An LED panel 1 may be configured by combining the LED module 10 having the plurality of LED elements 11 arranged according to a desired size and shape.

The LED module 10 may include a red LED element emitting red (R) light, a green LED element emitting green (G) light, and a blue LED element emitting blue (B) light. Each one of the LED elements 11 may be referred to as a dot.

For example, the red LED element, the green LED element and the blue LED element may be arranged in a matrix form, or the red LED element, the green LED element, and the blue LED element may constitute one package, and these packages may implement one pixel.

A plurality of the packages may be arranged in a matrix form to configure one of the LED modules 10. The LED module 10 may function as a minimum unit for displaying contents on the LED panel 1. In addition, the plurality of LED modules 10 may be combined to form a larger unit, or such units may be combined again to form one large screen.

A unit in which the plurality of LED modules 10 are combined is also referred to as a cabinet or a tile. Alternatively, in some cases, the LED module 10 may be referred to as a cabinet or a tile regardless of the terminology that is actually referred to. In the embodiment, the basic unit independently controlled while configuring one screen may be configured as the LED module 10.

In the display apparatus 100 according to an embodiment, as illustrated in FIG. 1, the plurality of LED modules 10 may be arranged in a two-dimensional matrix form, and as shown in FIG. 2, it is also possible to be arranged in one dimension. That is, the display apparatus 100 according to an embodiment does not limit the number of the LED modules 10 constituting one of the LED panels 1 or the manner in which the LED modules 10 are arranged.

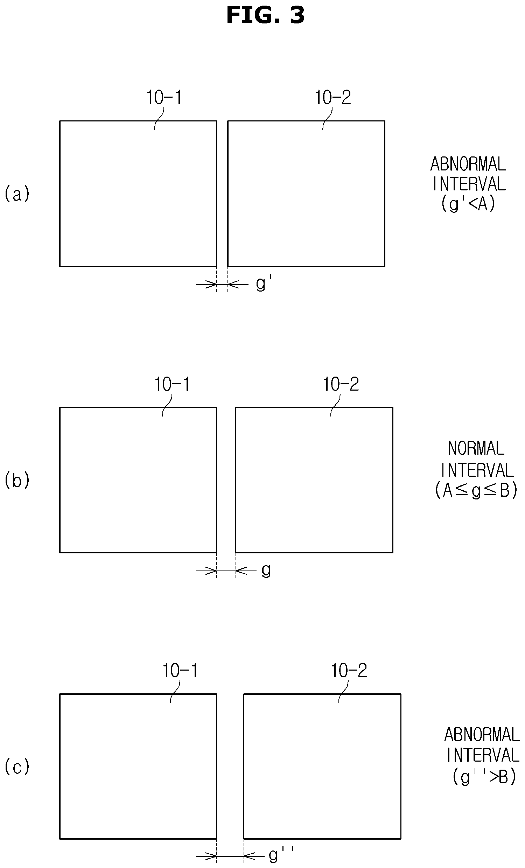

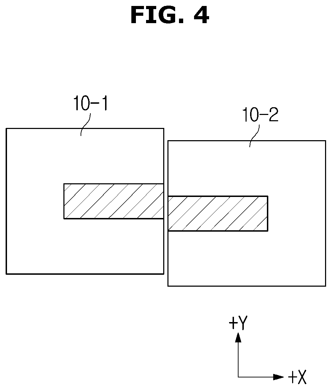

FIG. 3 is a view illustrating a case where an interval between LED modules is normal and abnormal in a display apparatus according to an embodiment, and FIG. 4 is a view illustrating a case in which an alignment of an LED module is misaligned.

Since the display apparatus 100 has a modular structure manufactured by combining the plurality of LED modules 10, the boundary of the display apparatus 100 may be visually recognized by a viewer if the interval between the LED modules 10 is not constant.

Referring to FIG. 3, when an interval g (g is an integer of 0 or more) between a plurality of LED modules 10-1 and 10-2 is a normal range (b), the interval g may be a value included in a predetermined range in which a gap between the plurality of LED modules 10-1 and 10-2 is normal. For example, in the case of A ≤ g ≤ B (A and B are integers greater than or equal to 0 and A = g = B), when an interval g' between the plurality of LED modules 10-1 and 10-2 is an abnormal interval smaller than the lower limit A of a normal range (a), a white seam may be visually recognized at the boundary thereof. When an interval g" between the plurality of LED modules 10-1 and 10-2 is an abnormal interval larger than the upper limit B of a normal range (c), a black seam may be visually recognized at the boundary thereof.

In addition, as illustrated in FIG. 4, when the plurality of LED modules 10-1 and 10-2 are not aligned in a straight line and are shifted, an image displayed on the LED panel 1 can be broken or a break occurs in the image. In addition, when the misalignment affects the other LED modules in the vicinity, the entire image may be pushed.

In the embodiment, a case where the LED module is pushed in an X-axis direction is expressed as shifted in the X-axis direction, and the case where the LED module is pushed in a Y-axis direction is expressed as shifted in the Y-axis direction.

In the example of FIG. 4, when the plurality of LED modules 10-1 and 10-2 are pushed in the Y-axis direction, in other words, the case is shifted in the Y-axis direction, or in the case where the plurality of LED modules 10-1 and 10-2 are arranged in the Y-axis direction, it is of course possible to shift in the X-axis direction.

Therefore, the alignment state between the LED modules 10 is normally maintained. If not, it is necessary to perform maintenance to adjust the alignment state of the LED module 10, or to perform a process for correcting or compensating for an abnormal alignment state. To this end, it is required to accurately measure the alignment state of the LED module 10, which will be described below in detail with respect to the embodiment of the alignment state measurement of the LED module 10. Here, measuring the alignment state of the LED module 10 may include both determining whether the alignment of the LED module is misaligned, and determining whether an interval between the LED modules 10 is included in a normal range.

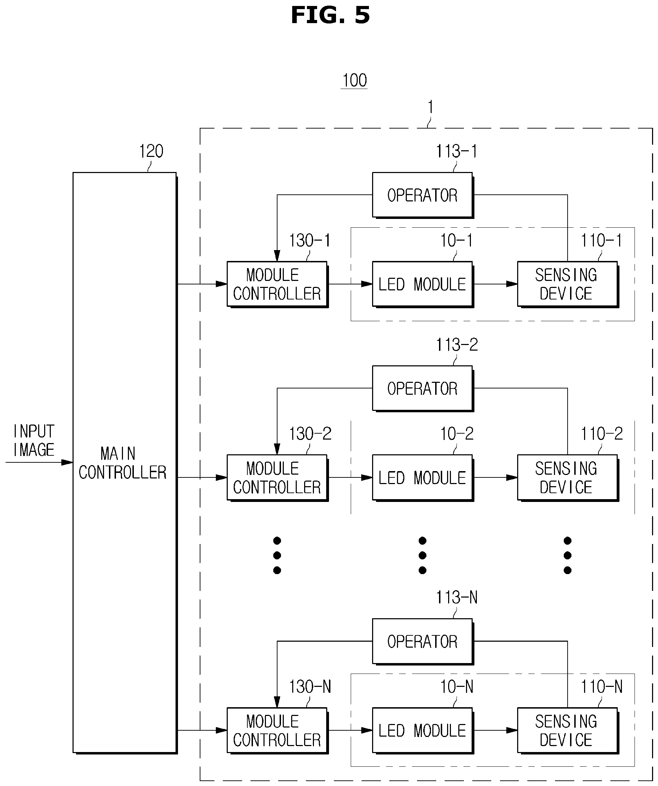

FIG. 5 is a control block diagram of a display apparatus according to an embodiment.

Referring to FIG. 5, the display apparatus 100 may include a main controller 120 for converting an input image into a form that can be displayed by the LED panel 1, and the LED panel 1 for displaying the input image in which the form is converted.

The input image may be input from an external device through a communication network, or may be input from a recording medium such as a USB, a hard disk drive, an optical disk drive, or a flash memory. Alternatively, it may be input from a separate playback device such as a computer or a DVD player. Accordingly, the display apparatus 100 may be an interface that performs wireless communication with an external device or is connected to a recording medium or a reproduction device to receive data.

The main controller 120 may convert the input image into image data in a form that the LED panel 1 can output, and may divide the input image according to the plurality of LED modules 10-1, 10-2, ..., and 10-N constituting the LED panel 1. When there are the N LED modules (N is an integer of 2 or more), the main controller 120 may divide the input image into N.

In addition, the main controller 120 may allocate the divided input image to each of the LED modules 10-1, 10-2, ..., and 10-N corresponding thereto. That is, each of the LED modules 10-1, 10-2, ..., and 10-N may be allocated a divided image to be output by the corresponding LED module.

The main controller 120 may transmit the image data for the divided image to each of module controllers 130-1, 130-2, ..., and 130-N corresponding to the divided image.

Based on the transmitted divided image data, each of the module controllers 130-1, 130-2, ..., and 130-N may generate a control signal so that each of the LED modules 10-1, 10-2, ..., 10-N outputs the divided image allocated thereto. For example, when the LED module 10 is driven by a PWM method, each of the module controllers 130-1, 130-2, ..., and 130-N may generate a PWM control signal for three of the RGB channels LED, thereby provide the generated PWN control signal to the modules 10-1, 10-2, ..., 10-N.

Each of the LED modules 10-1, 10-2, ..., and 10-N may include the plurality of LED elements 11 and a driving circuit (not shown) for driving them. The driving circuit may drive the plurality of LED elements 11 according to the transmitted PWM control signal to display the divided image allocated to the corresponding LED module 10.

In addition, the display apparatus 100 is installed on a rear surface of the LED module 10, and may further include an operator 113 for measuring the interval between or determining whether the alignment is misaligned based on an output of a sensing device 110 and the sensing device 110 for measuring the alignment state of the LED module 10. The sensing device 110 may include a transmitter for transmitting a signal and a receiver for receiving a signal.

The operator 113 may include a plurality of operators 113-1, 113-2, ..., and 113-N that receive output values from each of the LED modules 10-1, 10-2, ..., and 10-N. Each of the operators 113-1, 113-2, ..., and 113-N may determine the alignment state of the LED module 10 and the result of the determination is determined by the each of the module controllers 130-1, 130-2, ..., and 130-N. Each of the module controllers 130-1, 130-2, ..., and 130-N may perform control on the LED module 10 based on the alignment state determination result.

The operator 113 may include a memory for storing a program for determining whether the calculated interval is a normal interval, an abnormal interval, and a black seam generation (calculated interval > reference value) or a white seam generation (calculated interval < reference value) if the calculated interval is the abnormal interval by calculating the interval between the LED modules 10 and comparing the calculated interval with a preset reference value and a processor for executing the stored program.

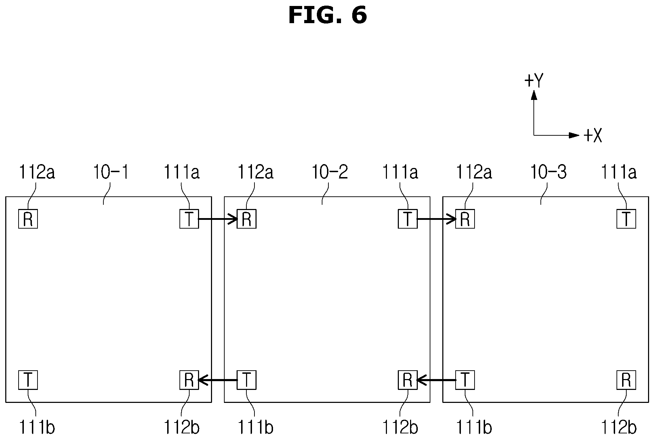

FIG. 6 is a view illustrating an example of arranging a sensing device applied to a display apparatus according to an embodiment.

The sensing device 110 may employ various sensors used for distance measurement, such as an optical sensor, an ultrasonic sensor, and a laser sensor using electromagnetic waves such as infrared rays and visible light. In the following embodiment, a case of employing an infrared sensor for convenience of description will be described as an example.

Referring to the example of FIG. 6, transmitters 111a and 111b and receivers 112a and 112b may be installed on a rear surface of the single LED module 10-1. Each of the transmitters 111a and 111b and each of the receivers 112a and 112b may be installed on an edge of the LED module 10-1 to receive a signal from a transmitter 111 installed in another one of the adjacent LED modules 10 or to emit a signal to a receiver 112.

When the LED module 10-1 has a quadrangular shape, as illustrated in FIG. 6, the sensing device 110 installed along one side of the quadrangle may include a transmitter and a receiver as a set. The remaining LED modules 10-2 and 10-3 may also have the same sensor arrangement as the LED module 10-1 described above. In the arrangement, the sensing devices 110 disposed at a boundary between the adjacent LED modules 10 may have a configuration corresponding to each other. That is, the receivers 112a and 112b may be disposed at positions corresponding to or opposite to the transmitters 111a and 111b disposed at the boundary.

Here, the transmitter 111 and the receiver 112 installed in the same LED module 10 do not transmit and receive the infrared rays. The transmitter 111 may emit the infrared rays toward the receiver 112 installed in the adjacent LED module 10, and the receiver 112 may receive the infrared rays emitted from the transmitter 111 installed in the adjacent LED modules 10. In this case, the interval between two of the adjacent LED modules 10 may be obtained from the outputs of the two transmitters 111a and 111b disposed at the boundary between the two LED modules 10, respectively.

For example, the interval between the first LED module 10-1 and the second LED module 10-2 may be obtained from the output of the receiver 112b of the first LED module 10-1 disposed at the boundary. The interval between the first LED module 10-1 and the second LED module 10-2 may also be obtained from the output of the receiver 112a of the second LED module 10-2 disposed at the boundary. As will be described later, when the operator 113 is provided independently for each of the LED modules 10, each of the operators 113 may independently obtain the interval between the LED module 10 assigned and the adjacent LED module without receiving information from the adjacent LED module.

In the example of FIG. 6, only three of the LED modules are illustrated for convenience of description, but the display apparatus 100 according to the embodiment may include a greater number of the LED modules.

The leftmost LED module 10-1 is referred to as the first LED module 10-1, and then the LED module 10-2 is referred to as the second LED module 10-2, and the rightmost LED module 10 is referred to as the third LED module 10-3. An ordinal number, such as first and second, are used only to distinguish each of the LED modules 10, and the order thereof has no meaning.

In the following description, terms indicating the direction of the left, right, upper side, lower side, and the like indicate relative directions based on a state of looking at the front surface of the LED module 10. When an XY-axis direction is set as illustrated in FIG. 6, an + X-axis direction corresponds to a right direction, an - X-axis direction corresponds to a left direction, a + Y-axis direction corresponds to an upper direction, and a - Y-axis direction corresponds to a lower direction.

The transmitter 111a installed on the upper right edge of the first LED module 10-1 may emit the infrared rays toward the + X-axis direction. The emitted infrared rays may be received by the receiver 112a installed on the upper left edge of the second LED module 10-2.

In addition, the transmitter 111b installed on the lower left edge of the second LED module 10-2 may emit the infrared rays toward the - X-axis direction. The emitted infrared rays may be received by the receiver 112b installed on the lower right edge of the second LED module 10-2.

In addition, the infrared rays emitted from the transmitter 111a installed on the upper right edge of the second LED module 10-2 may be received by the receiver 112a installed on the upper left edge of the third LED module 10-3. In addition, the infrared rays emitted from the transmitter 111b installed on the lower left edge of the third LED module 10-3 may be received by the receiver 112b installed on the lower right edge of the second LED module 10-2.

The outputs of the receivers 112a and 112b installed in each of the LED modules 10-1, 10-2, and 10-3 may be transmitted to the operator 113. The outputs of the receivers 112a and 112b may be voltage values having a magnitude corresponding to the amount of infrared rays received.

The outputs of the receivers 112a and 112b may be transmitted to the operator 113 in analog form or may be transmitted in digital form. When transmitted in the analog form, it may be converted to the digital form in the operator 113 as needed.

The operator 113-1 corresponding to the first LED module 10-1 may obtain both the distance from the LED module adjacent to the left side of the first LED module 10-1 and the distance from the second LED module 10-2 adjacent to the right side of the first LED module 10-1 based on the outputs of the receivers 112a and 112b of the first LED module 10-1. For example, the operator 113-1 may previously store the intensity of the infrared rays emitted from the transmitter 111b of the second LED module 10-2 or the output value of the receiver corresponding thereto, and may calculate the distance between the first LED module 10-1 and the second LED module 10-2 using the intensity of the infrared rays received by the receiver 112b of the first LED module 10-1 and the previously stored intensity of the infrared rays.

Similarly, the operator 113-2 corresponding to the second LED module 10-2 may obtain both the distance from the first LED module 10-1 adjacent to the left side of the second LED module 10-2 and the distance from the third LED module 10-3 adjacent to the right side of the second LED module 10-2 based on the outputs of the receivers 112a and 112b of the second LED module 10-2. For example, the operator 113-2 may previously store the intensity of the infrared rays emitted from the transmitter 111a of the first LED module 10-1 or the output value of the receiver corresponding thereto, and may calculate the distance between the first LED module 10-1 and the second LED module 10-2 using the intensity of the infrared rays received by the receiver 112a of the second LED module 10-2 and the previously stored intensity of the infrared rays.

In addition, the operator 113-3 corresponding to the third LED module 10-3 may obtain the distance between the second LED module 10-2 and the third LED module 10-3 based on the output of the receiver 112a disposed at the boundary with the second LED module 10-2. For example, the operator 113-3 may previously store the intensity of the infrared rays emitted from the transmitter 111a of the second LED module 10-2 or the output value of the receiver corresponding thereto, and may calculate the distance between the second LED module 10-2 and the third LED module 10-3 using the intensity of the infrared rays received by the receiver 112a of the third LED module 10-3 and the previously stored intensity of the infrared rays.

When another LED module is present on the right side of the third LED module 10-3, the infrared rays may be emitted from the transmitter 111a of the third LED module 10-3 toward the receiver of the another LED module adjacent to the right side. The receiver 113b of the third LED module 10-3 may receive the infrared rays emitted from the transmitter of the another LED module adjacent to the right side. Through this, the distance between the LED module adjacent to the right side of the third LED module 10-3 and the third LED module 10-3 may be obtained.

The same applies to the case where another LED module is present on the left side of the first LED module 10-1.

As described above, the distance from the LED module adjacent to the right side may be obtained from the output of the receiver 112b installed on the right edge of each of the LED modules 10-1, 10-2, and 10-3, and the distance from the LED module adjacent to the left side may be obtained from the output of the receiver 112a installed on the left edge.

Each of the operators 113-1, 113-2,..., and 113-N does not need the output of the receiver installed in the other LED module or an operation result of the other operator 113, and may independently obtain the distance from the LED modules adjacent to the left and right sides only by only the output of the receiver installed in the LED module 10 to which they are assigned.

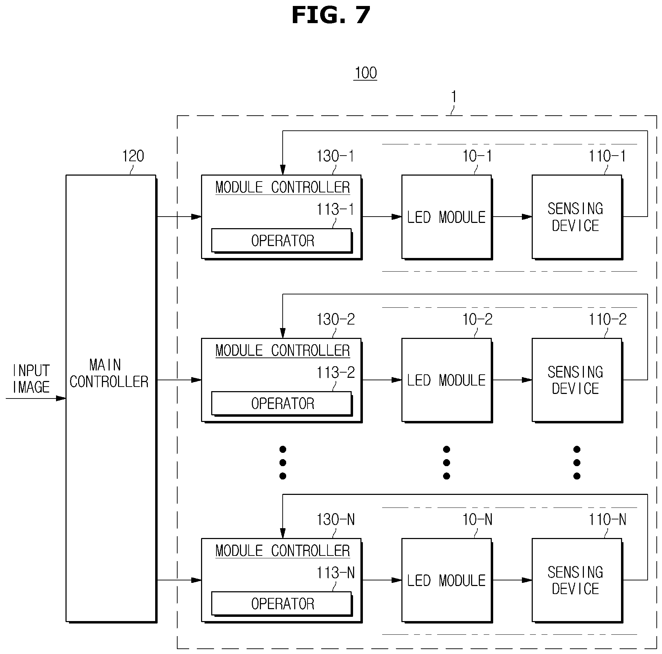

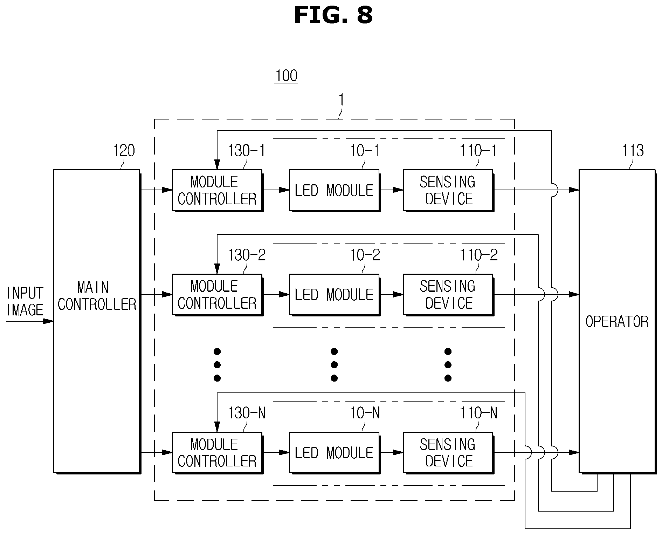

FIG. 7 is a control block diagram illustrating a case where an operator is included in a module controller in a display apparatus according to an embodiment. FIG. 8 is a control block diagram illustrating a case where a signal output from a plurality of LED modules is processed by one operator in a display apparatus according to an embodiment.

Referring to FIG. 7, the operators 113-1, 113-2, ..., and 113-N for determining the alignment state of each of the LED modules 10-1, 10-2, ..., and 10-N may be included in the module controllers 130-1, 130-2, ..., and 130-N. In this case, the operation of the operator 113 may be performed by the module controller 130. That is, the operator 113 and the module controller 130 may share the memory or the processor. Alternatively, the memory or the processor implementing the operator 113 may be integrated on a chip implementing the module controller 130.

The output of the receiver installed in each of the LED modules 10-1, 10-2, ..., and 10-N may be transmitted to the module controllers 130-1, 130-2, ..., and 130-N. Even in this case, the description of the operations performed by each of the operators 113-1, 113-2, ..., and 113-N is as described above.

Alternatively, as illustrated in FIG. 8, one of the operators 113 may receive the outputs of the receivers 112a and 112b from the plurality of LED modules 10-1, 10-2, ..., and 10-N.

In this case, the operator 113 may obtain the distance between two of the LED modules 10 adjacent to each other by two paths. Referring to the example of FIG. 6 described above, the operator 113 may receive information necessary to obtain the distance between the first LED module 10-1 and the second LED module 10-2 from both the receiver 112b of the first LED module 10-1 and the receiver 112a of the second LED module 10-2.

Therefore, the operator 113 may obtain more accurate distance information by combining the output of the receiver 112b of the first LED module 10-1 with the output of the receiver 112a of the second LED module 10-2 in an average manner.

Hereinafter, a method of obtaining the distance between the LED modules 10 adjacent in the Y-axis direction will be described.

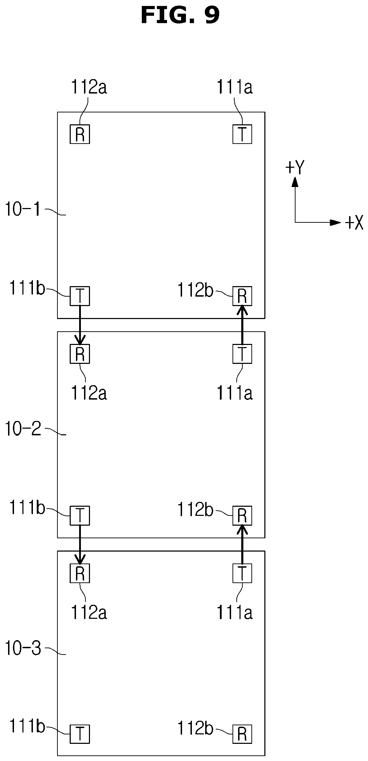

FIG. 9 is a view illustrating an interval measurement in a Y-axis direction of a plurality of LED modules having an arrangement of the sensing device of FIG. 6.

Referring to FIG. 9, each of the plurality of LED modules 10-1, 10-2, and 10-3 may have the same arrangement of the sensing device 110 as described above with reference to FIG. 6. However, the plurality of LED modules 10-1, 10-2, and 10-3 are arranged in the Y-axis direction.

The infrared rays emitted from the transmitter 111b installed on the left side of the lower edge of the first LED module 10-1 may be received by the receiver 112a installed on the left side of the upper edge of the second LED module 10-2.

In addition, the infrared rays emitted from the transmitter 111a installed on the right side of the upper edge of the second LED module 10-2 may be received by the receiver 112b installed on the right side of the lower edge of the first LED module 10-1.

In addition, the infrared rays emitted from the transmitter 111b installed on the left side of the lower edge of the second LED module 10-2 may be received by the receiver 112a installed on the left side of the upper edge of the third LED module 10-3. In addition, the infrared rays emitted from the transmitter 111a installed on the right side of the upper edge of the third LED module 10-3 may be received by the receiver 112b installed on the right side of the lower edge of the second LED module 10-2.

The operator 113-1 corresponding to the first LED module 10-1 may obtain the distance from the LED module adjacent to the upper side of the first LED module 10-1 and the distance from the second LED module 10-2 adjacent to the lower side of the first LED module 10-1 based on the outputs of the receivers 112a and 112b of the first LED module 10-1.

Similarly, the operator 113-2 corresponding to the second LED module 10-2 may obtain the distance from the LED module adjacent to the upper side of the second LED module 10-2 and the distance from the third LED module 10-3 adjacent to the lower side of the second LED module 10-2 based on the outputs of the receivers 112a and 112b of the second LED module 10-2.

The same description may be applied to the remaining LED modules.

Alternatively, when one of the operators 113 integrally processes signals transmitted from the plurality of LED modules 10-1, 10-2, ..., and 10-N as illustrated in FIG. 8, the operator 113 may obtain the distance between two of the LED modules 10 adjacent to each other by two paths. For example, the operator 113 may receive information necessary to obtain the distance between the first LED module 10-1 and the second LED module 10-2 from both the receiver 112b of the first LED module 10-1 and the receiver 112a of the second LED module 10-2.

Therefore, the operator 113 may obtain more accurate distance information by combining the output of the receiver 112b of the first LED module 10-1 with the output of the receiver 112a of the second LED module 10-2 in an average manner.

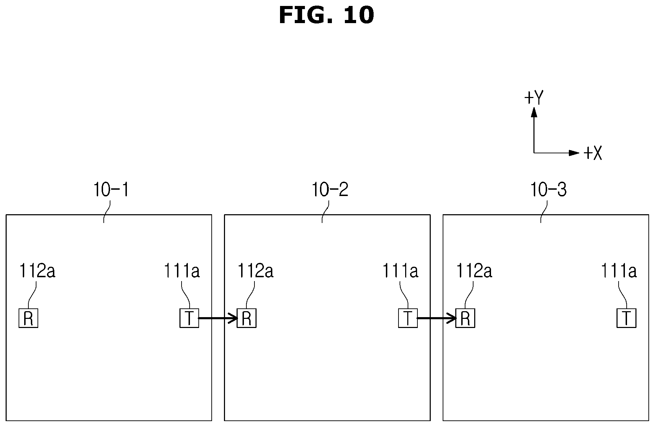

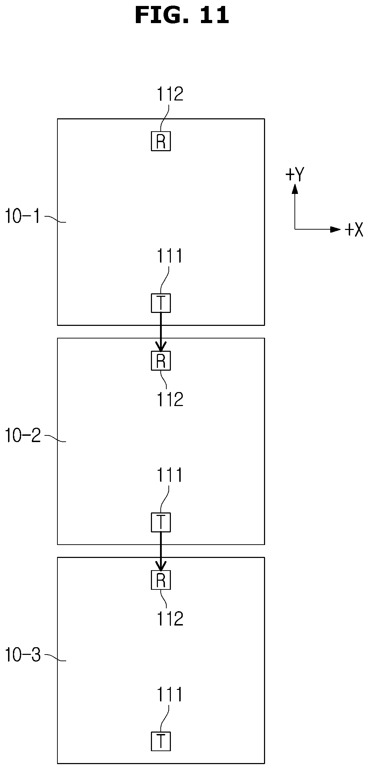

FIGS. 10 and 11 are views illustrating an arrangement of a sensing device that is possible when one operator receives an output of the sensing device from a plurality of LED modules.

When one of the operators 113 can receive the output of the sensing device 110 from the plurality of LED modules, one of the two adjacent LED modules may only emit the infrared rays to the other, and the other may only receive the infrared rays.

Referring to FIG. 10, one of the transmitter 111 and the receiver 112 may be disposed at the right edge of each of the LED modules 10-1, 10-2, and 10-3 arranged in the X-axis direction, and the other of the transmitter 111 and the receiver 112 may be disposed at the left edge of each of the LED modules 10-1, 10-2, and 10-3 arranged in the X-axis direction.

The infrared rays emitted from the transmitter 111 of the first LED module 10-1 may be received by the receiver 112 of the second LED module 10-2, and the infrared rays emitted from the transmitter 111 of the second LED module 10-2 may be received by the receiver 112 of the third LED module 10-3.

The operator 113 may obtain the interval between the first LED module 10-1 and the second LED module 10-2 from the output value of the receiver 112 disposed in the second LED module 10-2, and may obtain the interval between the second LED module 10-2 and the third LED module 10-3 from the output value of the receiver 112 disposed in the third LED module 10-3.

Referring to FIG. 11, one of the transmitter 111 and the receiver 112 may be disposed at the lower edge of each of the LED modules 10-1, 10-2, and 10-3 arranged in the Y-axis direction, and the other of the transmitter 111 and the receiver 112 may be disposed at the upper edge of each of the LED modules 10-1, 10-2, and 10-3 arranged in the Y-axis direction.

The infrared rays emitted from the transmitter 111 of the first LED module 10-1 may be received by the receiver 112 of the second LED module 10-2, and the infrared rays emitted from the transmitter 111 of the second LED module 10-2 may be received by the receiver 112 of the third LED module 10-3.

The operator 113 may obtain the interval between the first LED module 10-1 and the second LED module 10-2 from the output value of the receiver 112 disposed in the second LED module 10-2, and may obtain the interval between the second LED module 10-2 and the third LED module 10-3 from the output value of the receiver 112 disposed in the third LED module 10-3.

According to the examples of FIGS. 10 and 11, the number of sensing devices and operators may be reduced, resulting in cost savings and space savings.

In the above example, although the case where the plurality of LED modules are arranged one-dimensional along the X-axis direction or the Y-axis direction has been described as an example, even when the plurality of LED modules are arranged two-dimensional, the above-described example may be applied to measure the distance between the adjacent LED modules in the X-axis direction or the distance between the adjacent LED modules in the Y-axis direction.

Hereinafter, a method of obtaining both the distance between the LED modules 10 adjacent in the X-axis direction and the distance between the LED modules 10 adjacent in the Y-direction will be described.

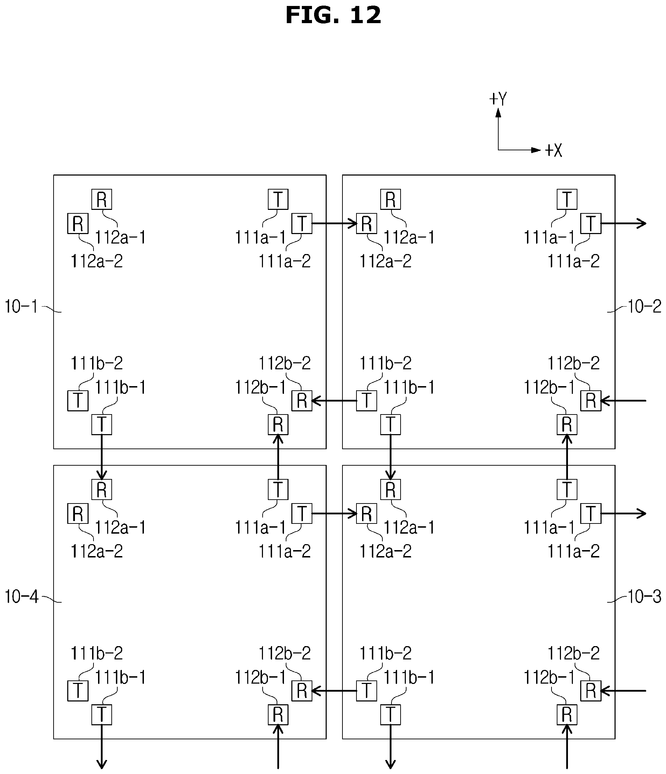

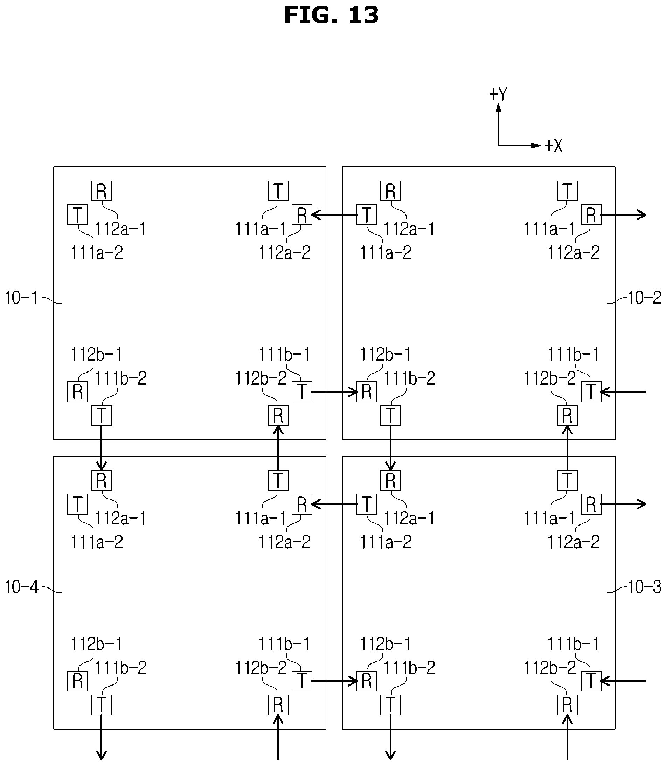

FIGS. 12 and 13 are views for describing an operation of obtaining a distance between LED modules adjacent in an X-axis direction and a Y-axis direction when a plurality of the LED modules are arranged in a two-dimensional matrix form in a display apparatus according to an embodiment.

For convenience of description, the LED module 10 is arranged in a 2x2 matrix form as an example, and the first LED module 10-1, the second LED module 10-2, and a fourth LED module 10-4 may be referred to in the clockwise direction from the upper left LED module.

Each of the LED modules 10-1, 10-2, 10-3, and 10-4 may be disposed with transmitters 111a-2 and 111b-2 that emit the infrared rays in the X-axis direction and receivers 112a-2 and 112b-2 that receive the infrared rays coming in the X-axis direction. Each of the LED modules 10-1, 10-2, 10-3, and 10-4 may be disposed with transmitters 111a-1 and 111b-1 that emit the infrared rays in the Y-axis direction and receivers 112a-1 and 112b-1 that receive the infrared rays coming in the Y-axis direction.

In each of the LED modules 10-1, 10-2, 10-3, and 10-4, the first transmitter 111a-1 installed on the right side of the upper edge may emit the infrared rays in the + Y-axis direction, and the first transmitter 111b-1 installed on the left side of the upper edge may emit the infrared rays in the - Y-axis direction.

In each of the LED modules 10-1, 10-2, 10-3, and 10-4, the second transmitter 111a-2 installed on the upper right edge may emit the infrared rays in the + X-axis direction, and the second transmitter 111b-2 installed on the lower left edge may emit the infrared rays in the - X-axis direction.

In each of the LED modules 10-1, 10-2, 10-3, and 10-4, the first receiver 112a-1 installed on the left side of the upper edge may receive the infrared rays coming from the + Y-axis direction, and the first receiver 112b-1 installed on the right side of the upper edge may receive the infrared rays coming from the - Y-axis direction.

In each of the LED modules 10-1, 10-2, 10-3, and 10-4, the second receiver 112a-2 installed on the upper left edge may receive the infrared rays coming from the - X-axis direction, and the second receiver 112b-2 installed on the lower right edge may receive the infrared rays coming from the + X-axis direction.

The infrared rays emitted from the second transmitter 111a-2 installed on the upper right edge of the first LED module 10-1 may be received by the second receiver 112a-2 installed on the upper left edge of the second LED module 10-2.

In addition, the infrared rays emitted from the second transmitter 111b-2 installed at the lower left edge of the second LED module 10-2 may be received by the second receiver 112b-2 installed at the lower right edge of the first LED module 10-1.

The infrared rays emitted from the second transmitter 111a-2 installed on the upper right edge of the fourth LED module 10-4 may be received by the second receiver 112a-2 installed on the upper left edge of the third LED module 10-3.

In addition, the infrared rays emitted from the second transmitter 111b-2 installed at the lower left edge of the third LED module 10-3 may be received by the second receiver 112b-2 installed at the lower right edge of the fourth LED module 10-4.

The operator 113 may obtain the distance from the adjacent LED module in the X-axis direction based on the outputs of the second receiver 112a-2 installed on the upper left edge of each of the LED modules 10-1, 10-2, 10-3, and 10-4 and the second receiver 112b-2 installed on the lower right edge of each of the LED modules 10-1, 10-2, 10-3, and 10-4, and may determine whether it is the normal interval, the abnormal interval, a black seam generation state or a white seam generation state. Alternatively, it may be determined whether the alignment is misaligned.

As the examples of FIGS. 5 and 7 described above, the operator 113 may be provided for each of the LED modules to independently determine the alignment state between the adjacent LED modules, and as illustrated in FIG. 8, one of the operators 113 may receive the outputs of the receivers from the plurality of LED modules and determine the integrated result.

The infrared rays emitted from the first transmitter 111b-1 installed on the left side of the lower edge of the first LED module 10-1 may be transmitted by the first receiver 112a-1 installed on the left side of the upper edge of the fourth LED module 10-4.

In addition, the infrared rays emitted from the first transmitter 111a-1 installed on the right side of the upper edge of the fourth LED module 10-4 may be received by the first receiver 112b-1 installed on the right side of the lower edge of the first LED module 10-1.

In addition, the infrared rays emitted from the first transmitter 111b-1 installed on the left side of the lower edge of the second LED module 10-2 may be received by the first receiver 112a-1 installed on the left side of the upper edge of the third LED module 10-3.

In addition, the infrared rays emitted from the first transmitter 111a-1 installed on the right side of the upper edge of the third LED module 10-3 may be received by the first receiver 112b-1 installed on the right side of the lower edge of the second LED module 10-2.

The operator 113 may obtain the distance from the adjacent LED module in the Y-axis direction based on the outputs of the first receiver 112b-1 installed on the lower right edge of each of the LED modules 10-1, 10-2, 10-3, and 10-4 and the first receiver 112a-1 installed on the upper left edge of each of the LED modules 10-1, 10-2, 10-3, and 10-4, and may determine whether it is the normal interval, the abnormal interval, a black seam generation state or a white seam generation state. Alternatively, it may be determined whether the alignment is misaligned.

As the example of FIG. 7 described above, the operator 113 may be provided for each of the LED modules to independently determine the alignment state between the adjacent LED modules, and as illustrated in FIG. 8, one of the operators 113 may receive the outputs of the receivers from the plurality of LED modules and determine the integrated result.

The transmitters 111a-2 and 111b-2 that emit the infrared rays in the X-axis direction and the transmitters 111a-1 and 111b-1 that emit the infrared rays in the Y-axis direction may simultaneously emit the infrared rays, or may sequentially emit the infrared rays at time intervals.

The alignment state between the LED modules may be measured by transmitting / receiving in real time while the display apparatus 100 is powered on. An initial measurement may be performed when the power is turned on, and then the alignment state may be measured periodically. When a user inputs a command for measuring the alignment state between the LED modules through an inputter provided in the display apparatus 100, a measurement may be performed.

Alternatively, it is possible to perform the measurement when an external device, for example, a user terminal or a service server / management server, which is wirelessly connected to the display apparatus 100, transmits a status check request for maintenance. In this case, the display apparatus 100 may include a communication circuitry communicating with the external device, and may receive the status check request from the external device through the communication circuitry and transmit an alignment state measurement result to the external device.

In the display apparatus 100 according to the embodiment, there is no limitation on the timing of measuring the alignment state of the LED module.

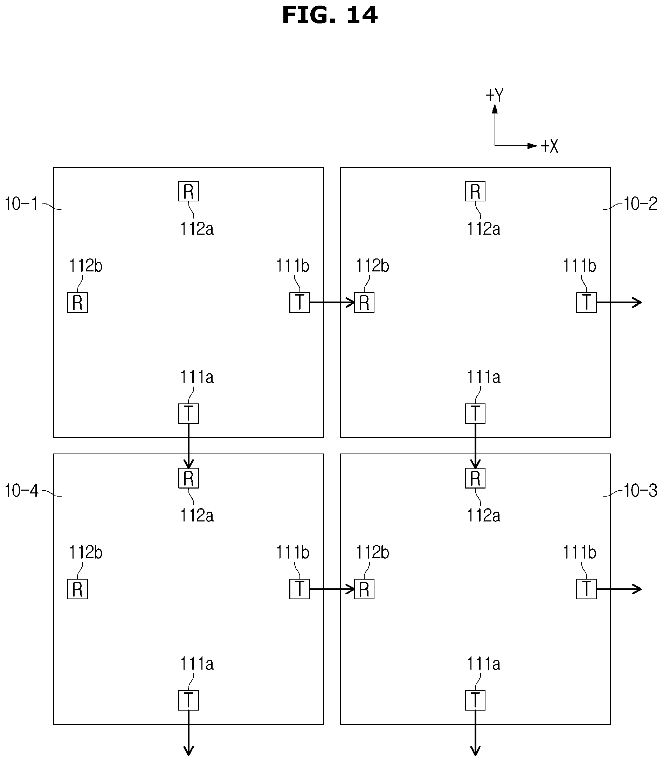

FIG. 14 is a view illustrating another arrangement of a sensing device that is possible when one operator receives an output of the sensing device from a plurality of LED modules.

As described above in the examples of FIGS. 10 and 11, when one of the operators 113 can receive the output of the sensing device 110 from the plurality of LED modules, one of the two adjacent LED modules may only emit the infrared rays to the other, and the other may only receive the infrared rays. This description is also applicable when measuring the interval between the adjacent LED modules in the X-axis direction and the Y-axis direction.

As illustrated in FIG. 14, the receiver 112 or the transmitter 111 may be disposed on the upper edge and the left edges of each of the LED modules 10-1, 10-2, 10-3, and 10-4. In the lower edge and the right edge, the transmitter 111 or the receiver 112 that is not disposed on the upper edge and the left edge may be disposed. Although FIG. 14 illustrates that each of the receiver and the transmitter are disposed at the edge center of the LED module, the embodiment of the display apparatus 100 is not limited thereto, and each of the receiver and the transmitter may be disposed at the corners of the LED module.

The infrared rays emitted from the second transmitter 111b of the first LED module 10-1 may be received by the second receiver 112b of the second LED module 10-2, and the infrared rays emitted from the first transmitter 111a of the first LED module 10-1 may be received by the first receiver 112a of the fourth LED module 10-4.

The infrared rays emitted from the first transmitter 111a of the second LED module 10-2 may be received by the first receiver 112a of the third LED module 10-3, and the infrared rays emitted from the second transmitter 111b of the fourth LED module 10-4 may be received by the second receiver 112b of the third LED module 10-3.

The operator 113 may obtain the interval between the first LED module 10-1 and the second LED module 10-2 adjacent in the X-axis direction from the output value of the second receiver 112b disposed in the second LED module 10-2, and may obtain the interval between the second LED module 10-2 and the third LED module 10-3 adjacent in the Y-axis direction from the output value of the first receiver 112a disposed in the third LED module 10-3.

The operator 113 may obtain the interval between the third LED module 10-3 and the fourth LED module 10-4 adjacent in the X-axis direction from the output value of the second receiver 112b disposed in the third LED module 10-3, and may obtain the interval between the fourth LED module 10-4 and the first LED module 10-1 adjacent in the Y-axis direction from the output value of the first receiver 112a disposed in the fourth LED module 10-4.

On the other hand, even if one of the operators 113 is provided with output from the plurality of LED modules, it is of course also possible to have the same sensor arrangement as if each of the LED modules having the operator 113.

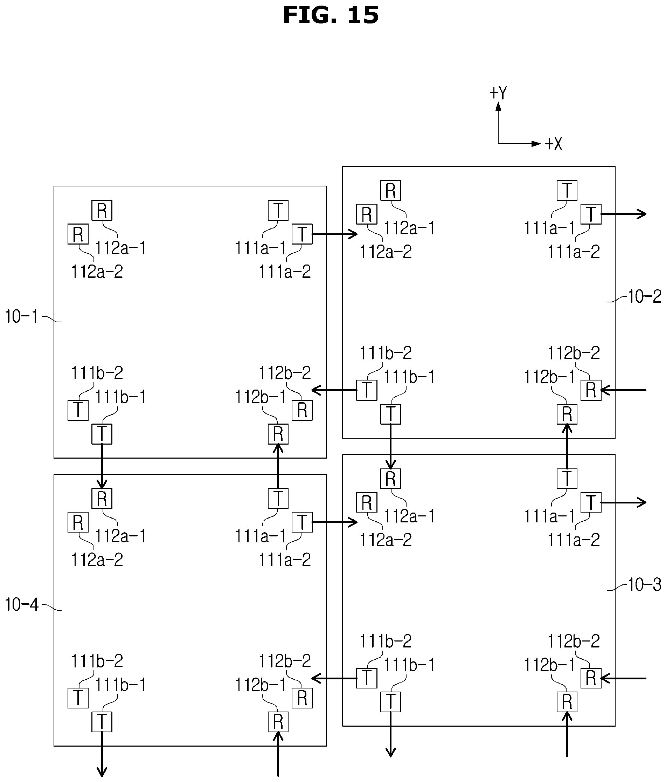

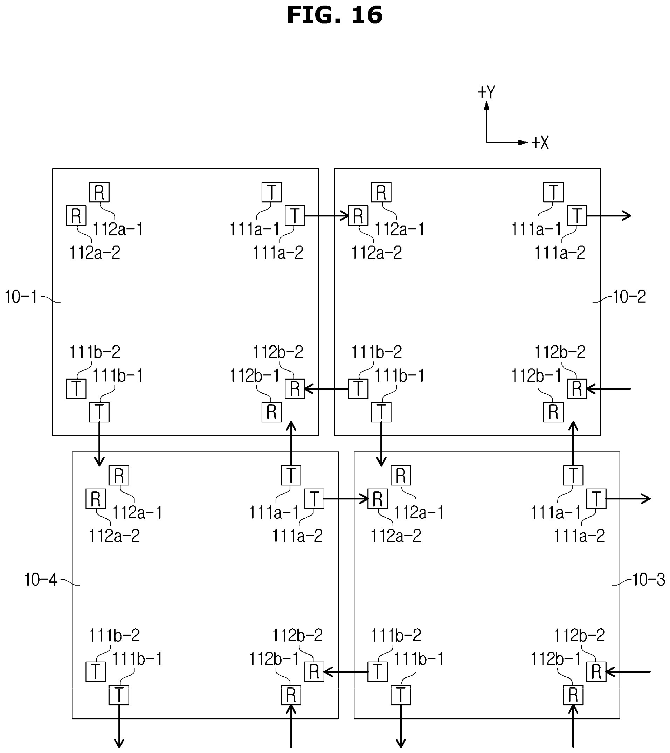

FIGS. 15 and 16 are views illustrating an operation of a sensing device in a case in which an alignment of an LED module is misaligned in a display apparatus according to an embodiment.

Referring to FIG. 15, when the alignment of the LED module 10 is misaligned in the Y-axis direction, the second receiver 112a-2 installed on the upper left edge or the first receiver 112b-1 installed on the lower right edge to receive the infrared rays coming from the X-axis direction, may not receive the infrared rays or receive less than a reference value. Accordingly, the operator 113 may determine that the alignment of the LED module 10 is misaligned in the Y-axis direction when the output value of the second receiver 112a-2 installed on the upper left edge or the first receiver 112b-1 installed on the lower right edge is less than a preset reference value.

Referring to FIG. 16, when the alignment of the LED module 10 is misaligned in the X-axis direction, the first receiver 112a-1 installed on the left side of the upper edge or the second receiver 112b-2 installed on the right side of the lower edge to receive the infrared rays coming from the Y-axis direction, may not receive the infrared rays or receive less than the reference value. Accordingly, the operator 113 may determine that the alignment of the LED module 10 is misaligned in the X-axis direction when the output value of the first receiver 112a-1 is installed on the left side of the upper edge or the second receiver 112b-2 is installed on the right side of the lower edge is less than the preset reference value.

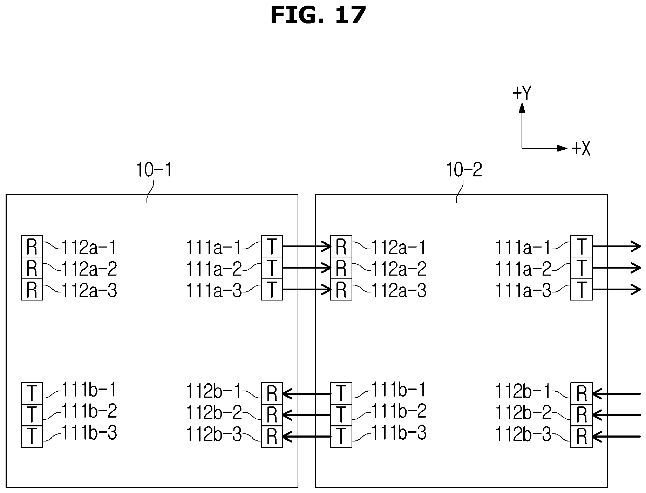

FIGS. 17 to 20 are views illustrating a case in which a sensing device is provided in an array form in a display apparatus according to an embodiment.

The example of FIG. 6 described above corresponds to a case in which the receivers 112a and 112b that receive the infrared rays coming from the X-axis direction and the transmitters 111a and 111b that emit the infrared rays in the X-axis direction are provided in a single configuration. However, embodiments of the display apparatus 100 are not limited thereto. As illustrated in FIG. 17, when the plurality of LED modules 10-1 and 10-2 are arranged in the X-axis direction, the plurality of receivers 112a-1, 112a-2, and 112a-3 that receive the infrared rays coming from the - X-axis direction, may be arranged in a row to form an array.

Similarly, the plurality of receivers 112b-1, 112b-2 and 112b-3 that receive the infrared rays coming from the + X-axis direction, may be arranged in the row to form the array.

In addition, the plurality of transmitters 11a-1, 111a-2, and 111a-3 that emit the infrared rays in the + X-axis direction, may be arranged in the row to form the array.

Similarly, the plurality of transmitters 111b-1, 111b-2, and 111b-3 that emit the infrared rays in the -X-axis direction, may be arranged in the row to form the array.

As described above, the operator 113 may obtain the distance between the adjacent LED modules in the X-axis direction based on a value output from each of the receivers 112b-1, 112b-2, and 112b-3. For example, when the operator 113 is provided for each of the LED modules as illustrated in FIGS. 5 and 7 described above, the values that the operator 113-1 provided in the first LED module 10-1 can use to measure the distance in the X-axis direction between the first LED module 10-1 and the second LED module 10-2 are output values output from the plurality of receivers 112b-1, 112b-2, and 112b-3. The operator 113-1 may combine these values in an averaged manner to obtain a more accurate distance than using only one of the receivers output. In addition, even when an error occurs in some of the plurality of receivers or the plurality of transmitters, the distance can be measured using the remaining receivers or transmitters.

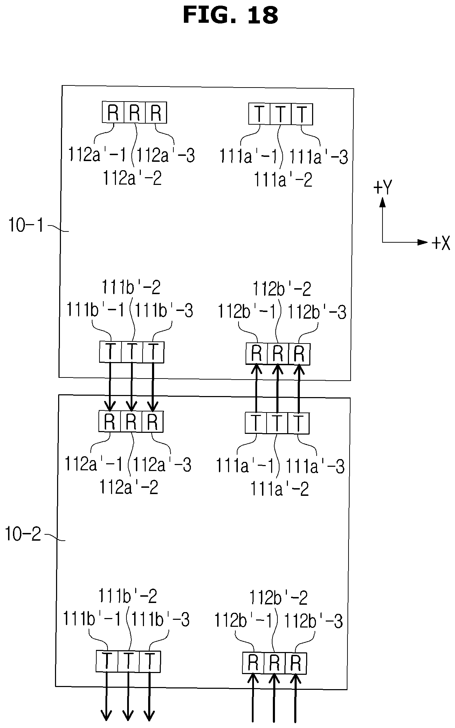

As illustrated in FIG. 18, when the plurality of LED modules 10-1 and 10-2 are arranged in the Y-axis direction, the plurality of receivers 112b-1, 112b-2, and 112b-3 that receive the infrared rays coming from the -Y-axis direction, may be arranged in the row to form the array.

Similarly, a plurality of receivers 112a'-1, 112a'-2, and 112a'-3, which receive the infrared rays coming from the + Y-axis direction, may be arranged in the row to form the array.

In addition, a plurality of transmitters 111a'-1, 111a'-2, and 11a'-3, which emit the infrared rays in the + Y-axis direction, may be arranged in the row to form the array.

Similarly, a plurality of transmitters 111b'-1, 111b'-2, and 111b'-3, which emit the infrared rays in the -Y-axis direction, may be arranged in the row to form the array.

As described above, the operator 113 may obtain the distance between the adjacent LED modules in the X-axis direction based on a value output from each of the receivers 112b-1, 112b-2, and 112b-3. For example, when the operator 113 is provided for each of the LED modules as illustrated in FIGS. 5 and 7 described above, the operator 113-1 provided in the first LED module 10-1 may obtain the distance between the first LED module 10-1 and the second LED module 10-2 by combining the output values output from a plurality of receivers 112b'-1, 112b'-2, and 112b'-3.

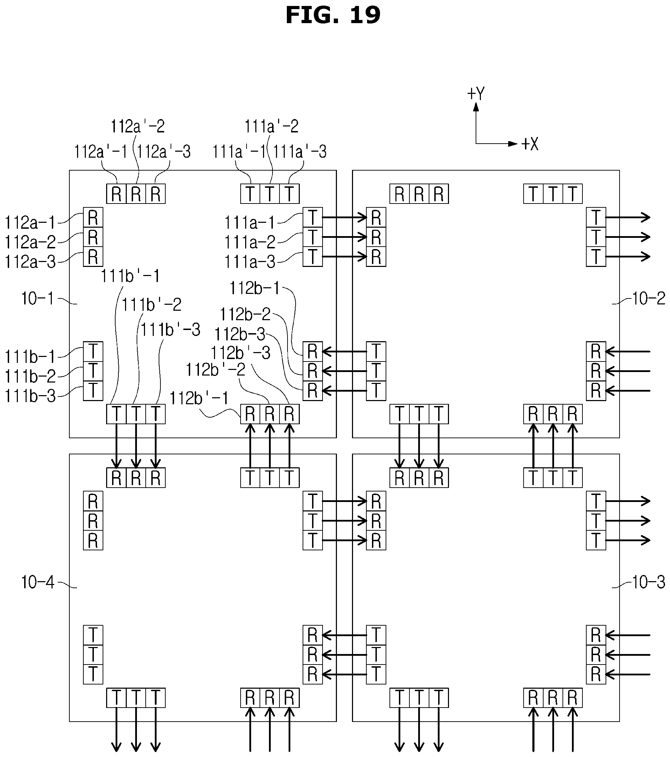

Meanwhile, when the plurality of LED modules 10-1, 10-2, 10-3, and 10-4 are arranged in the two-dimensional matrix form, by combining the arrangement of the sensing device 110 of FIG. 17 and the arrangement of the sensing device 110 of FIG. 18, the sensing device 110 may be arranged in a structure as illustrated in FIG. 19. The description of the arrangement and operation of each of the transmitter and the receiver is the same as described above, and thus detailed descriptions are omitted here.

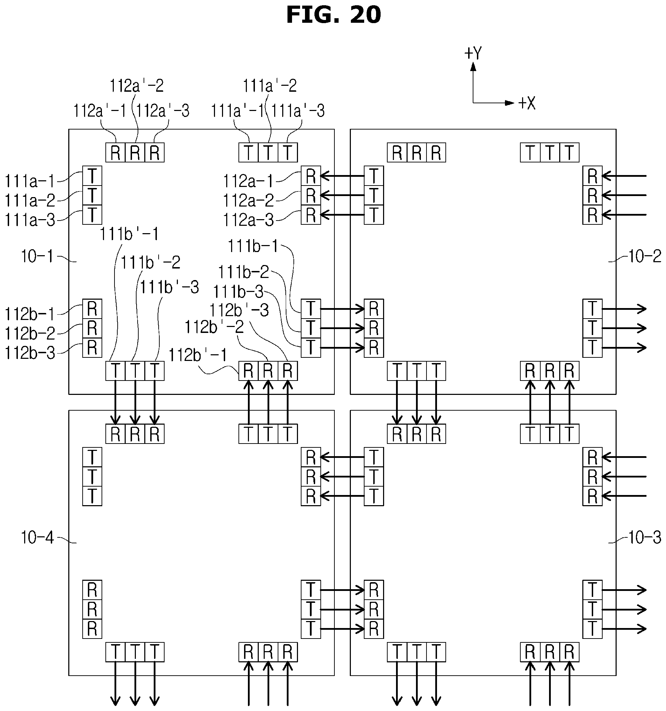

Alternatively, as illustrated in FIG. 20, the sensing device arrangements of the upper right, upper left, lower right and lower left of the LED module 10 may be configured by a combination of the transmitter and the receiver.

Particularly, the plurality of receivers 112a-1, 112a-2, and 112a-3 may be installed on the upper right edge to receive the infrared rays coming from the + X-axis direction, and the plurality of transmitters 111a'-1, 111a'-2, and 111a'-3 may be installed on the right side of the upper edge to emit the infrared rays in the + Y-axis direction.

The plurality of receivers 112a'-1, 112a'-2, and 112a'-3 may be installed on the left side of the upper edge to receive the infrared rays from the + Y-axis direction, and the plurality of transmitters 111a-1, 111a-2, and 111a-3 may be installed on the upper left edge to emit the infrared rays in the -X-axis direction.

The plurality of receivers 112b-1, 112b-2, and 112b-3 may be installed on the lower left edge to receive the infrared rays from the -Y-axis direction, and the plurality of transmitters 111b'-1, 111b'-2, and 111b'-3 may be installed on the left side of the lower edge to emit the infrared rays in the -Y-axis direction.

The plurality of receivers 112b'-1, 112b'-2, and 112b'-3 may be installed on the right side of the lower edge to receive the infrared rays from the - Y-axis direction, and the plurality of transmitters 111b-1, 111b-2, and 111b -3 may be installed on the lower right edge to emit the infrared rays in the + X-axis direction.

The distance measurement using the output of the receiver has been described above.

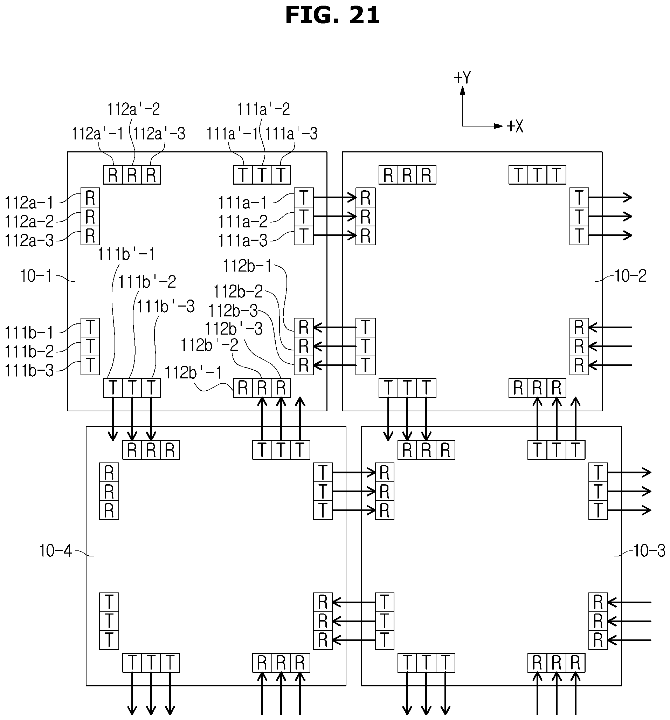

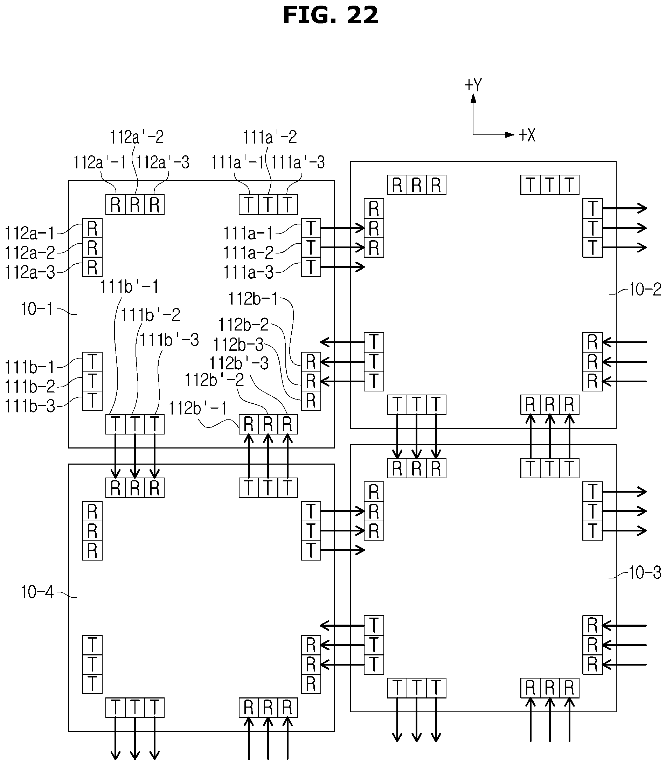

FIG. 21 is a view illustrating a case in which an alignment of an LED module is misaligned in an X-axis direction in a display apparatus having an arrangement of the sensing device of FIG. 19. FIG. 22 is a view illustrating a case in which an alignment of an LED module is misaligned in a Y-axis direction in a display apparatus having an arrangement of the sensing device of FIG. 19.

Referring to FIG. 21, when the alignment of the LED module 10 is misaligned in the X-axis direction, at least one of the plurality of receivers 112a'-1, 112a'-2, and 112a'-3 installed on the left side of the upper edge for receiving the infrared rays coming from the Y-axis direction or at least one 112b'-1 of the plurality of receivers 112b'-1, 112b'-2, and 112b'-3 installed on the right side of the lower edge, may not receive the infrared rays or receive less than the reference value.

Accordingly, the operator 113 may determine that the alignment of the LED module 10 is misaligned in the X-axis direction when there is a value less than the preset reference value among the output values of the plurality of receivers 112a'-1, 112a'-2, and 112a'-3 installed on the left side of the upper edge or the plurality of receivers 112b'-1, 112b'-2, and 112b'-3 installed on the right side of the lower edge.

Referring to FIG. 22, when the alignment of the LED module 10 is misaligned in the Y-axis direction, at least one of the plurality of receivers 112a-1, 112a-2, and 112a-3 installed on the upper left edge for receiving the infrared rays coming from the X-axis direction or at least one 112b-1 of the plurality of receivers 112b-1, 112b-2, and 112b-3 installed on the lower right edge, may not receive the infrared rays or receive less than the reference value.

Accordingly, the operator 113 may determine that the alignment of the LED module 10 is misaligned in the X-axis direction when there is the value less than the preset reference value among the output values of the plurality of receivers 112a-1, 112a-2, and 112a-3 installed on the upper left edge or the plurality of receivers 112b-1, 112b-2, and 112b-3 installed on the lower right edge.

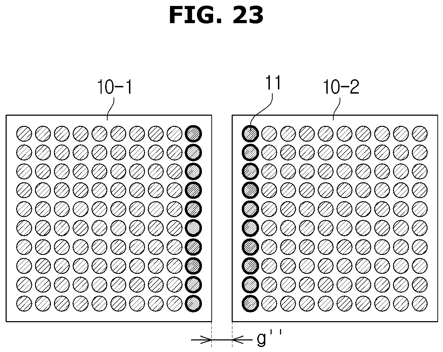

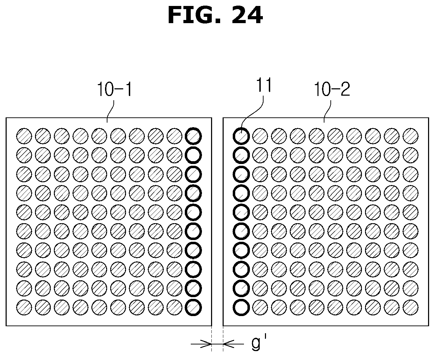

FIGS. 23 and 24 are views illustrating an operation for compensating for a case in which an interval between LED modules is abnormal.

As described above, the operator 113 may obtain the interval between the LED modules 10 based on the output of the sensing device 110, and may determine whether the obtained interval is the normal interval or the abnormal interval. As described above, the normal interval may have a certain range. The operator 113 may determine that the obtained interval is the abnormal interval when the obtained interval is greater than an upper limit value or a lower limit value of a preset normal interval range.

When the operator 113 determines that the interval between the LED modules 10 is the abnormal interval, the module controller 130 may remove a black seam or a white seam by controlling brightness of the LED element 11 disposed at the boundary between the two LED modules 10-1 and 10-2 having the abnormal interval.

As illustrated in FIG. 23, when the interval between the two LED modules 10-1 and 10-2 is greater than the normal interval, the module controllers 130-1 and 130-2 may remove the black seam by increasing the brightness of the LED element 11 disposed at the boundaries of the two LED modules 10-1 and 10-2. In this case, the amount of increased brightness may be preset as a default value or may be set differently according to the distance between the two LED modules 10-1 and 10-2. In the latter case, as the distance between the two LED modules 10-1 and 10-2 increases, the amount of increased brightness may also increase.

When the module controller 130 generates the control signal for increasing the brightness of the LED element 11 disposed at the boundary and transmits the control signal to the LED module 10, the driving circuit may generate a driving signal for increasing the brightness of the LED element 11 according to the transmitted control signal, and may transmit the driving signal to the LED device 11.

As illustrated in the example of FIG. 24, when the interval between the two LED modules 10-1 and 10-2 is smaller than the normal interval, the module controllers 130-1 and 130-2 may remove the white seam by reducing the brightness of the LED element 11 disposed at the boundary between the two LED modules 10-1 and 10-2. In this case, the amount of reduced brightness may also be preset as the default value, or may be set differently according to the distance between the two LED modules 10-1 and 10-2. In the latter case, as the distance between the two LED modules 10-1 and 10-2 approaches, the amount of reduced brightness may also increase.

When the module controller 130 generates the control signal for reducing the brightness of the LED element 11 disposed at the boundary and transmits the control signal to the LED module 10, the driving circuit may generate the driving signal for reducing the brightness of the LED element 11 according to the transmitted control signal, and may transmit the driving signal to the LED device 11.

The module controller 130-1 controlling the first LED module 10-1 may generate the control signal for increasing or decreasing the brightness of the LED element 11 disposed at a right boundary of the first LED module 10-1. The module controller 130-2 controlling the second LED module 10-2 may generate the control signal for increasing or decreasing the brightness of the LED element 11 disposed at a left boundary of the second LED module 10-2.

On the other hand, when the alignment between the LED modules 10 is misaligned, it is also possible to minimize an image broken phenomenon through image correction.

Alternatively, the display apparatus 100 may induce the user to receive a repair by outputting a warning to the user of the display apparatus 100 without directly performing compensation for the removal of the white seam / black seam or correction of the image broken phenomenon.

For example, it is possible to output the warning to one area of the LED panel 1 of the display apparatus 100, or to output the warning to the external device through the communication circuitry of the display apparatus 100. For example, the warning may be output through the user terminal wirelessly connected to the display apparatus 100, or the warning may be output to the management server or the service server to allow a manager of the display apparatus 100 to perform maintenance.

Hereinafter, an embodiment of a control method of the display apparatus will be described. In the control method of the display apparatus according to an embodiment, the above-described display apparatus 100 may be used. Therefore, the above descriptions of FIGS. 1 to 24 may be equally applied to the control method of the display apparatus, unless otherwise noted.

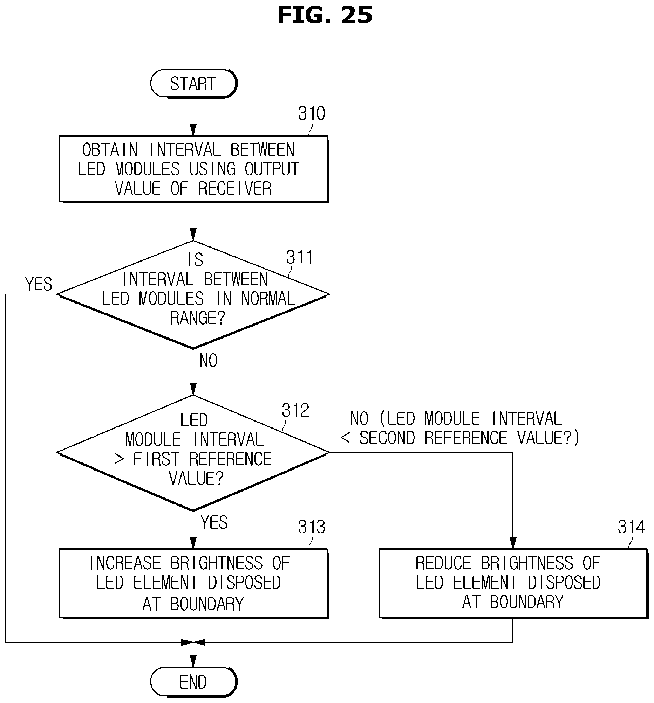

FIG. 25 is a flowchart illustrating a control method for measuring an interval between LED modules and performing compensation according to the measured interval.

Referring to FIG. 25, the operator 113 may obtain the interval between the LED modules using the output value of the receiver (310). The transmitter 111 and the receiver 112 may be installed at the rear of the LED module 10 and may have the arrangement as described in the embodiment of the display apparatus 100. When the receiver 112 receives the signal transmitted from the transmitter 111 disposed in the adjacent LED module, the receiver 112 may output the output value corresponding to the strength of the received signal.

As illustrated in FIGS. 5 and 7, the operator 113 may be provided for each of the LED modules 10 to independently obtain the interval between the LED module 10 and the adjacent LED module 10. When the sensing device arrangement of the LED module 10 is the same as the example of FIG. 12 described above, the operator 113-1 provided for the first LED module 10-1 may obtain the interval between the first LED module 10-1 and the LED module adjacent in the X-axis direction or the Y-axis direction from the output values of the plurality of receivers 112a-1, 112a-2, 112b-1, and 112b-2 installed in the first LED module 10-1.

Alternatively, as illustrated in FIG. 8, the operator 113 may integrally output the output values output from the sensing devices 110-1, 110-2, ..., 110-N installed in the plurality of LED modules 10-1, 10-2, ..., 10-N.

The operator 113 determines whether the interval between the LED modules is the normal range (311). The normal range is a range in which the interval between the LED modules can be viewed as the normal interval, which may mean a range in which the black seam or the white seam are not visible to the viewer. The normal range may be preset.

When the interval between the LED modules is not the normal range (NO in 312), and when the interval between the LED modules is greater than a first reference value indicating the upper limit of the normal range (YES in 312), it is determined that the black seam may appear between the LED modules, and the module controller 130 increases the brightness of the LED element 11 disposed at the boundary between the two LED modules (313). For example, when the module controller 130 generates the control signal for increasing the brightness of the LED element 11 disposed at the boundary and transmits the control signal to the LED module 10, the driving circuit may generate the driving signal for increasing the brightness of the LED element 11 according to the control signal and transmit the driving signal to the LED element 11 disposed at the boundary.

When the interval between the LED modules is less than a second reference value indicating the lower limit of the normal range (NO in 312), it is determined that the white seam may appear between the LED modules, and the module controller 130 reduces the brightness of the LED element 11 disposed at the boundary between the two LED modules (314). For example, when the module controller 130 generates the control signal for reducing the brightness of the LED element 11 disposed at the boundary and transmits the control signal to the LED module 10, the driving circuit may generate the driving signal for reducing the brightness of the LED element 11 according to the control signal and transmit the driving signal to the LED element 11 disposed at the boundary.

On the other hand, it is also possible to induce the display apparatus 100 to receive the repair for the LED module 10 by outputting the warning through the display apparatus 100 or the external device without directly performing compensation.

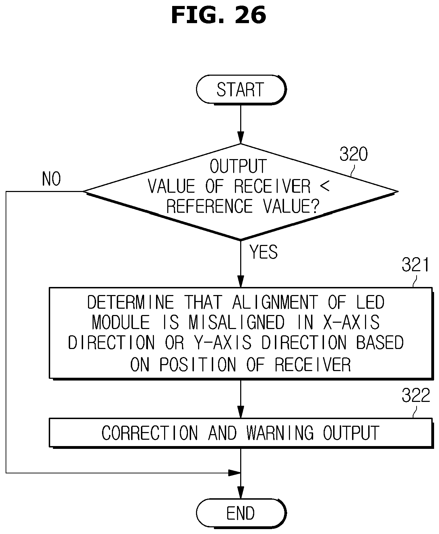

FIG. 26 is another flowchart related to a control method of determining a misalignment of an LED module in a method of controlling a display apparatus according to an embodiment.

Referring to FIG. 26, the operator 113 may compare the output value of the receiver with the preset reference value (320). When the output value of the receiver is less than the preset reference value (YES in 320), the operator 113 may determine that the alignment of the LED module 10 in which the corresponding receiver 112 is disposed is misaligned.

At this time, the operator 113 may determine that the alignment of the LED module 10 is misaligned in the X-axis direction or the Y-axis direction based on the position of the receiver 112 (321). For example, when the receiver 112 is disposed at the left edge or the right edge of the LED module 10 to receive the signal emitted from the left side or the right side, the operator 113 may determine that the corresponding LED module 10 is pushed or misaligned in the Y-axis direction. Alternatively, when the receiver 112 is disposed at the upper edge or the lower edge of the LED module 10 to receive the signal emitted from the upper side or the lower side, the operator 113 may determine that the corresponding LED module 10 is pushed or misaligned in the X-axis direction.

When the alignment of the LED module 10 is misaligned, a phenomenon in which an image displayed on a screen composed of the plurality of LED modules 10 is broken may occur. Therefore, the main controller 120 may output the warning to minimize the image broken phenomenon through the image correction or to receive the repair for the misaligned LED module 10 (322).

According to the embodiments of the display apparatus and the method of controlling the same, it is possible to measure the alignment state of the LED module simply and accurately by employing a simple sensor structure. In addition, it is possible to measure the alignment state of the LED module in real time. When it is determined that there is a problem in the alignment state, by controlling the brightness of the LED element independently for each LED module, it is possible to promptly improve the degradation of image quality.

## Claims

1. A display apparatus comprising:
a plurality of LED modules;
a plurality of module controllers configured to control the plurality of LED modules;
a plurality of transmitters disposed on a rear surface of the plurality of LED modules, and configured to transmit a signal toward one of the adjacent LED modules among the plurality of LED modules;
a plurality of receivers disposed on the rear surface of the plurality of LED modules, and configured to receive the signal transmitted from a transmitter of the adjacent LED module among the plurality of LED modules; and
at least one operator configured to obtain an interval between the LED modules adjacent to each other using output values of the plurality of receivers.

2. The display apparatus according to claim 1, wherein the at least one operator is configured to determine whether the interval between the LED modules adjacent to each other is included in a preset normal range.

3. The display apparatus according to claim 1, wherein the plurality of module controllers are configured to increase brightness of LED elements disposed at boundaries of the LED modules adjacent to each other when the interval between the LED modules adjacent to each other is greater than a preset first reference value.

4. The display apparatus according to claim 1, wherein the plurality of module controllers are configured to reduce brightness of LED elements disposed at boundaries of the LED modules adjacent to each other when the interval between the LED modules adjacent to each other is greater than a preset second reference value.

5. The display apparatus according to claim 1, wherein the at least one operator is configured to determine an alignment state of the plurality of LED modules using output values of the plurality of receivers.

6. The display apparatus according to claim 5, wherein the at least one operator is configured to:
compare the output values of the plurality of receivers with a preset reference value; and
when there is the output value less than the preset reference value among the output values of the plurality of receivers, determine that the alignment of the LED module in which the receiver that outputs the output value less than the preset reference value is misaligned.

7. The display apparatus according to claim 1, wherein the plurality of LED modules are arranged in a form of a one-dimensional or two-dimensional matrix on an XY plane.

8. The display apparatus according to claim 7,
wherein at least one of the plurality of transmitters are disposed on at least one edge of the plurality of LED modules, and
wherein the plurality of receivers are disposed at positions corresponding to the plurality of transmitters disposed in the adjacent LED modules.

9. The display apparatus according to claim 8,
wherein at least one of the plurality of transmitters are disposed at each of left and right edges of the plurality of LED modules, and
wherein at least one of the plurality of receivers are disposed at each of left and right edges of the plurality of LED modules.

10. The display apparatus according to claim 8,
wherein at least one of the plurality of transmitters are disposed at each of upper and lower edges of the plurality of LED modules, and
wherein at least one of the plurality of receivers are disposed at each of upper and lower edges of the plurality of LED modules.

11. The display apparatus according to claim 8, wherein the plurality of transmitters comprise:
at least one of the transmitters disposed at a left edge of the LED module to transmit a signal toward the LED module adjacent to the left side; and
at least one of the transmitters disposed at a right edge of the LED module to transmit a signal toward the LED module adjacent to the right side.

12. A method of controlling a display apparatus comprising:
transmitting signals toward LED modules adjacent to each other from a plurality of transmitters disposed at a rear surface of a plurality of the LED modules;
receiving, by a plurality of receivers disposed at the rear surface of the plurality of LED modules, the signals transmitted from the plurality of transmitters disposed at the LED modules adjacent to each other;
outputting, by the plurality of receivers, output values corresponding to strength of the received signals; and
obtaining a distance between the LED modules adjacent to each other using the output values.

13. The method according to claim 12, further comprising:
determining whether an interval between the LED modules adjacent to each other is included in a preset normal range.

14. The method according to claim 13, further comprising:
increasing brightness of LED elements disposed at boundaries of the LED modules adjacent to each other when the interval between the LED modules adjacent to each other is greater than a preset first reference value.

15. The method according to claim 13, further comprising:
reducing brightness of LED elements disposed at boundaries of the LED modules adjacent to each other when the interval between the LED modules adjacent to each other is greater than a preset second reference value.
